# FASCICULE DE BREVET EUROPEEN

(11) **EP 0 703 863 B1**
(45) Date de publication et mention de la délivrance du brevet: **05.04.2000**
(21) Numéro de dépôt: 94917717.4
(22) Date de dépôt: 03.06.1994
(51) Int. Cl.: B41M 1/34, C04B 41/52, C04B 41/45, H05K 3/10

(54) **PROCEDE DE REALISATION DE MOTIFS SUR DES OBJETS, NOTAMMENT EN CERAMIQUE**
VERFAHREN ZUR HERSTELLUNG VON MUSTERN AUF GEGENSTÄNDEN, INSBESONDERE AUF KERAMISCHEN GEGENSTÄNDEN
METHOD OF PRODUCING PATTERNS ON OBJECTS, ESPECIALLY CERAMIC ARTICLES

(30) Priorité: 03.06.1993 FR 9306652
(43) Date de publication de la demande: 03.04.1996
(73) Titulaire: BRAULT, Benoit, F-64390 Orriule (FR)
(72) Inventeur: BRAULT, Benoit, F-64390 Orriule (FR)
(86) Numéro de dépôt international: FR9400656
(87) Numéro de publication internationale: WO9429115

(56) Documents cités:
- EP-A- 0 414 363
- DE-A- 2 610 213
- DE-A- 3 740 149
- US-A- 4 420 501
- US-A- 4 710 253
- M.Hellmiss, R.Erker: Das grosse Bunte Bastelbuch, Ed. Loewe, pages 22,23.

## Description

La présente invention concerne un procédé de réalisation de motifs sur des objets, notamment de type silicaté.

Il est connu de réaliser par décalcomanie céramique des motifs ou des décors sur des supports céramiques. C'est ainsi que le brevet français FR 2697465, décrit un procédé faisant appel à l'impression thermique d'une image sur un substrat de transfert au moyen d'un ou plusieurs rubans pigmentés, au report par décalcomanie de cette image du substrat de transfert sur le support silicaté, et à une opération de recuit du support silicaté ainsi revêtu de l'image finale.

Cependant, le transfert d'une image par décalcomanie doit se faire sur un émail cuit car un émail cru serait trop friable. Il est nécessaire d'effectuer ensuite un recuit de l'objet revêtu de l'image afin de fixer définitivement sur l'objet les pigments céramiques dont est constituée la décalcomanie.

Ce procédé d'impression est difficilement compatible avec la production en grande série de certains objets de type silicaté ou métalliques tels que, par exemple, des ustensiles de cuisine, en raison de la nécessité d'une opération de recuit après transfert de la décalcomanie. En effet, une telle opération supplémentaire nécessiterait des investissements importants pour adapter les chaînes de fabrication, affecterait de manière sensible les coûts de fabrication ainsi que les cadences de production. En outre, l'automatisation à cadence élevée du transfert des décalcomanies sur des objets de surface développable ou gauche apparait délicate à mettre en oeuvre.

Il est également connu, notamment par la demande de brevet japonais No. 64-105647 déposée le 25 Avril 1989, de former un motif sur un objet en céramique par projection d'une composition pigmentée sur l'objet au moyen d'une imprimante du type à jet d'encre. Compte tenu de la technologie actuelle des imprimantes à jet d'encre, un tel procédé permet de réaliser des motifs avec une haute résolution, tant sur des émaux crus que cuits, ou sous émail.

Toutefois, la réalisation de motifs en couleur présentant une très grande résistance aux agressions mécaniques, chimiques ou autres impose d'utiliser des compositions pigmentées pour matières céramiques, à savoir des compositions constituées par l'association d'un pigment minéral (tel qu'oxyde et/ou sel de métal) à une fritte silicatée compatible avec le support. Or, la granulométrie de telles compositions, généralement de l'ordre de 5 à 20 micromètres, est trop importante vis-à-vis des buses des têtes d'impression à jet d'encre. Il y a donc un risque très important d'encrassage des buses, sauf à augmenter leur diamètre au détriment de la définition du motif qui sera réalisé. De plus, ces compositions pigmentées pour céramiques sont très abrasives et sont susceptibles d'endommager très rapidement les buses de la tête d'impression.

EP-A-0414363 et DE-A-3740149 décrivent, de leur côté, l'utilisation d'un dispositif à jet d'encre pour projeter sur un substrat un motif adhésif sur lequel on fait adhérer ensuite une composition métallique pulvérulente que l'on fusionne par chauffage pour former un motif, tel qu'un circuit, conducteur de l'électricité.

On connaît enfin d'après le livre "Das grosse bunte Bastelbuch" par Margot Hellmiss et Robert Erker, éditions Loewe, Février 1993, une méthode de décoration d'objets par un motif en couleurs consistant à (1) encoller la partie de l'objet devant être colorée en une première couleur, (2) saupoudrer la partie encollée avec du sable coloré de ladite première couleur, (3) éliminer l'excès de sable coloré, (4) répéter cette série d'opérations (1) à (3) avec un ou plusieurs sables de couleurs différentes. Des grains de riz, des lentilles ou des haricots peuvent aussi être collés sur les parties encollées et, finalement, le motif final est fixé par séchage de la colle.

L'invention vise à fournir un procédé de réalisation de motifs sur des objets qui permette de s'affranchir des limitations des procédés d'impression connus en offrant la possibilité de réaliser avec une haute résolution des motifs mono ou polychromes sur de nombreux types de supports tels que des supports silicatés, métalliques, en matière plastique, en bois, etc...

Les motifs réalisés peuvent être des motifs décoratifs, notamment polychromes, ou des motifs de marquage ou d'identification, par exemple des codes-barres. La réalisation de motifs conducteurs de l'électricité, tels que des circuits électriques, est en dehors du cadre de l'invention.

A cet effet, l'invention a pour objet un procédé de réalisation d'un motif à haute résolution sur un objet, qui comprend les étapes de :
a) projection sur un objet au moyen d'une tête d'impression de type à jet d'encre de gouttelettes d'une colle réparties selon un motif déterminé,
b) pulvérisation ou saupoudrage d'une composition pulvérulente, au moins sur une partie dudit objet présentant ledit motif,
c) traitement de la surface dudit objet pour en éliminer la composition déposée sur des zones dépourvues de colle, et
d) fixation définitive audit objet de la composition adhérant selon ledit motif, caractérisé en ce que ledit objet est en une matière silicatée, en ce qu'on réalise un motif polychrome à but décoratif, de marquage ou d'identification en répétant les étapes a), b) et c) pour chacune des couleurs du motif jusqu'à l'obtention du motif polychrome, en utilisant à chaque fois, comme composition pulvérulente, une composition comprenant un mélange de pigment minéral et d'une fritte silicatée compatible avec la matière silicatée de l'objet, exempte de particules conductrices de l'électricité, de la couleur désirée, et en ce que l'étape (d) de fixation des compositions pigmentées déposées consiste en une cuisson à une température comprise entre 500 et 1300°C.

La projection des gouttelettes de colle sur l'objet est assurée au moyen d'une tête d'impression du type à jet d'encre dans laquelle l'encre est remplacée par une colle ou composition adhésive de fluidité convenable. Ce procédé permet de s'affranchir complètement de la granulométrie de la composition pigmentée utilisée, cette granulométrie pouvant ainsi être optimisée en fonction, notamment, de la nature du support, de l'effet esthétique recherché, et de la résistance du motif aux agressions diverses. Suivant la nature du support auquel est appliqué le motif, c'est-à-dire de l'objet ou de sa surface, le traitement de fixation définitive pourra consister par exemple dans le dépôt d'une ou plusieurs couches de vernis, dans un traitement thermique de surface ou dans une cuisson de l'objet. Le procédé de l'invention peut être mis en oeuvre avec des céramiques crues, le traitement de fixation définitive consistant alors dans la cuisson finale de l'objet revêtu du motif. Enfin, grâce au pilotage de la tête d'impression projetant les gouttelettes de colle par un ordinateur comme cela est classique pour les imprimantes à jet d'encre, des motifs peuvent être aisément réalisés sur des surfaces planes, développables ou gauches, tandis que dans une ligne de fabrication les motifs peuvent être modifiés d'un objet à l'autre.

Aux fins de l'invention le terme "colle" désigne toutes substances capables de maintenir en place la composition pigmentée déposée depuis son application jusqu'à sa fixation définitive. La colle peut être, donc, non seulement une composition adhésive au sens usuel du terme, mais aussi d'autres substances telles que des liants, médiums, etc... capables d'assurer le maintien temporaire précité.

D'autres caractéristiques et avantages de l'invention ressortiront de la description qui va suivre faite en se référant aux dessins annexés sur lesquels :
- la figure 1 illustre l'étape de projection de gouttelettes de colle selon un motif déterminé sur un objet ;
- la figure 2 illustre l'étape de pulvérisation ou saupoudrage de la composition pigmentée sur l'objet revêtu de gouttelettes de colle à l'étape illustrée par la figure 1, et
- la figure 3 illustre l'étape de traitement de la surface de l'objet pour en éliminer la composition pigmentée dans les zones dépourvues de colle.

En se référant aux figures, un objet 1 tel qu'un carreau ou support céramique est présenté à un poste d'encollage comprenant une tête d'impression 2 pourvue d'une ou plusieurs rangées de buses 3 destinées à projeter sur le support 1 des gouttelettes de colle réparties selon un motif déterminé 4.

La tête 2 fait appel à la technique classique des imprimantes à jet d'encre du type à fonctionnement continu ou du type fonctionnant à la demande. De telles imprimantes sont disponibles dans le commerce, par exemple auprès de la Société Hewlett-Packard.

La colle utilisée doit être suffisamment fluide pour permettre la projection de gouttelettes de dimensions appropriées. Cette colle devra avoir une puissance d'adhésion suffisamment forte pour retenir les particules de la composition pigmentée lors du traitement ultérieur d'élimination de cette composition en dehors des zones encollées. Des exemples de types de colles convenant pour la mise en oeuvre du procédé compte tenu des différentes contraintes en présence seront donnés ci-après dans la description.

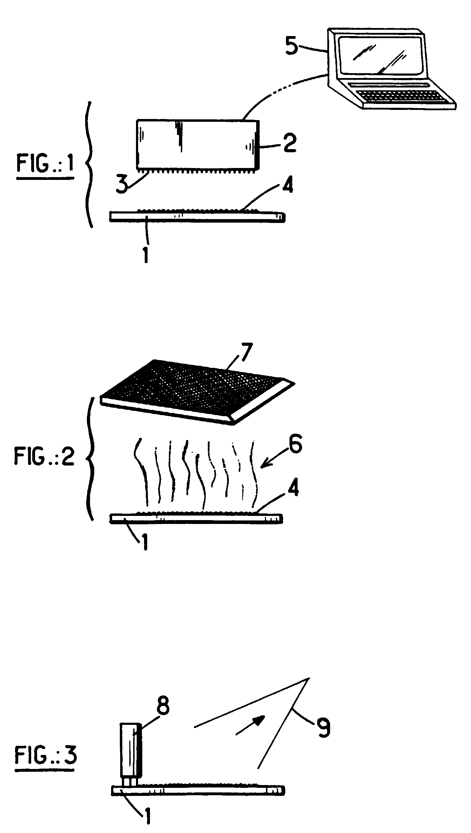

A l'étape illustrée par la figure 1, l'objet 1 est immobilisé et les déplacements de la tête 2 au-dessus de l'objet 1, ainsi que la projection de gouttelettes de colle par les buses 3, sont commandés de manière conventionnelle par un ordinateur 5 programmé pour former le motif désiré sur l'objet 1.

Une fois le motif en gouttelettes de colle réalisé sur le support 1, celui-ci est déplacé à un deuxième poste où une composition pigmentée 6 est pulvérisée ou saupoudrée sur l'objet 1, par exemple par agitation d'un tamis 7 contenant la composition comme représenté à la figure 2. Pour favoriser le dépôt de la composition pigmentée sur l'objet 1, celui-ci peut-être chargé électrostatiquement de manière à attirer la composition.

Une fois la colle 4 suffisamment sèche, l'objet 1 est soumis, comme représenté à la figure 3, à un traitement visant à éliminer la composition pigmentée de la surface de l'objet en dehors des zones où cette composition adhère à l'objet selon le motif formé par les gouttelettes de colle. Ce traitement peut consister, soit en un brossage au moyen d'une brosse 8, soit en une aspiration désignée par la référence 9 associée ou non avec un soufflage (non représenté) de la surface de l'objet, soit encore en une combinaison de ces différents moyens. Par exemple, si l'objet 1 est revêtu d'un émail cru, et est par conséquent poreux, de préférence un soufflage de la surface de l'objet est effectué combiné avec une aspiration destinée à recueillir les particules de la composition pigmentée chassées par le soufflage.

Après l'étape de projection des gouttelettes et avant l'étape de pulvérisation ou saupoudrage ou bien après l'étape de pulvérisation et avant l'élimination de la composition pigmentée excédentaire, il peut être désirable ou nécessaire de soumettre la colle, selon la nature de celle-ci, à une étape de traitement intermédiaire visant à renforcer ou développer les propriétés adhésives de la colle ou bien à accroître sa viscosité afin de réduire, par exemple, les risques de coulures. Ce traitement peut consister, par exemple, en un séchage partiel ou total de la colle par chauffage par exemple par passage dans un four ou exposition à un rayonnement infrarouge, ou bien en une exposition à un rayonnement ultra-violet ou à un faisceau d'électrons visant à effectuer un durcissement au moins partiel de la colle ou le développement de ses propriétés adhésives, ainsi que cela sera évident pour l'homme du métier.

L'objet peut être également soumis de manière facultative à une opération de roulage avant ou après le traitement d'élimination de la figure 3 afin d'uniformiser la couche de composition pigmentée adhérant aux parties encollées de l'objet.

Enfin, l'objet revêtu de la composition pigmentée distribuée selon le motif déterminé par les points de colle est soumis à un traitement de fixation définitive qui peut revêtir différentes formes suivant la nature du matériau dont est constitué l'objet 1.

Si l'objet est de type silicaté, par exemple une céramique, une tôle émaillée, un verre, le traitement consistera en une cuisson de l'objet à une température pouvant être comprise entre 500 et 1300°C environ selon le matériau concerné. Ce traitement thermique aura pour effet de volatiliser la colle et d'assurer, par fusion de la fritte contenue dans la composition pigmentée, une très bonne résistance du motif pigmenté aux agressions mécaniques, chimiques ou autres.

Si l'objet est en matière plastique, le traitement de fixation pourra consister par exemple en un vernissage mono ou multicouches ou en un traitement thermique de surface.

Dans le cas d'un objet en bois, le traitement de fixation consistera de préférence en un vernissage mono ou multicouches.

Enfin, s'agissant d'un objet en métal, le traitement de fixation pourra être de type thermique ou consister en un vernissage mono ou multicouches si le métal dont il s'agit ne peut supporter un traitement thermique.

Si le motif qui doit être réalisé sur l'objet 1 est polychrome, les étapes d'encollage, de pulvérisation ou saupoudrage de la composition pigmentée, et d'élimination de la composition pigmentée excédentaire, et si nécessaire les étapes complémentaires de séchage assisté et de roulage, seront répétées sur l'objet pour chacune des couleurs dont il convient d'effectuer l'impression au moyen d'une composition pigmentée appropriée.

Dans ce cas, le traitement de fixation définitive est de préférence effectué après encollage de toutes les compositions pigmentées destinées à former le motif. Toutefois, en variante, le traitement de fixation définitive peut être effectué à la fin de chaque phase de dépôt d'une couleur, notamment dans le cas du vernissage d'un objet en bois ou en matière plastique afin d'obtenir un meilleur état de surface, une plus grande résistance aux agressions du produit fini, et éviter une contamination possible entre les couleurs déposées successivement.

Comme colles pouvant être utilisées pour la mise en oeuvre du procédé décrit ci-dessus, on peut citer, à titre illustratif et non limitatif les colles à base d'amidon, les colles à base de polymères acryliques, les colles cyanoacryliques, des solutions de médiums, des solutions aqueuses d'un silicate de Na ou de K, etc...

Avantageusement, la formulation de colle utilisée présente une viscosité de 4 à 30 mPa.s et une tension superficielle de 2 à 6 x 10⁻⁴ N/cm.

On donne ci-dessous trois exemples de formulations de colles, en % en poids :

| | | |
|---|---|---|
| 1) | méthyléthylcétone | 50 |
| | Médium N° 81 W 1290 (vendu par Johnson Matthey) | 50 |
| 2) | colle au cyanoacrylate Loctite 406 (vendue par la Société Loctite Co.) | 40 |
| | butyrolactone | 50 |
| | méthyléthylcétone | 5 |
| | eau | 5 |
| 3) | solution de silicate de sodium (disponible dans le commerce auprès de la Société de Produits Chimiques CIRON) | 50 |
| | eau | 50 |
| 4) | Médium N° 81 W 464 (vendu par Johnson Matthey) | 100 |

La composition pigmentée comprend de préférence un pigment minéral (tel qu'oxyde et/ou sel de métal) associé à une fritte silicatée compatible avec le support du motif. Cette composition pigmentée est exempte de particules conductrices de l'électricité, telles que des particules métalliques ou de carbone, de façon à ne pas donner, après cuisson ou autre fixation, un motif conducteur de l'électricité. De telles compositions pigmentées sont bien connues dans la technique et n'ont pas besoin d'être décrites ici. Des exemples de poudres pigmentées disponibles dans le commerce qui conviennent sont les poudres spéciales pour lithographie sur émail, de la série 18, vendues par la Société Johnson Matthey. Ces poudres conviennent pour réaliser des motifs sur la plupart des supports.

Dans l'hypothèse où l'impression doit être faite sur un matériau de très grande porosité, celui-ci pourra être revêtu, préalablement à la première ou à chaque étape de projection de colle, d'une pellicule en matière plastique telle qu'une pellicule de polyéthylène, de polyester, etc... qui sera volatilisée lors de la cuisson de l'objet. En variante, on peut appliquer, au moins sur la partie de l'objet destinée à recevoir le motif, une couche primaire de colle ou autre enduit qui fermera la porosité après absorption par le substrat et sur laquelle on viendra réaliser la première projection de colle. L'application de la couche primaire peut s'effectuer à l'aide d'une tête d'impression du type à jet d'encre ou par tous autres moyens, par exemple par pulvérisation, au pinceau, au trempé, etc...

## Revendications

1. Procédé de réalisation d'un motif à haute résolution sur un objet, qui comprend les étapes de :
a) projection sur un objet (1) au moyen d'une tête d'impression (2) de type à jet d'encre de gouttelettes d'une colle réparties selon un motif déterminé (4),
b) pulvérisation ou saupoudrage d'une composition pulvérulente (6), au moins sur une partie dudit objet présentant ledit motif,
c) traitement de la surface dudit objet pour en éliminer la composition déposée sur des zones dépourvues de colle, et
d) fixation définitive audit objet de la composition adhérant selon ledit motif, caractérisé en ce que ledit objet est en une matière silicatée, en ce qu'on réalise un motif polychrome à but décoratif, de marquage ou d'identification en répétant les étapes a), b) et c) pour chacune des couleurs du motif jusqu'à l'obtention du motif polychrome, en utilisant à chaque fois, comme composition pulvérulente (6), une composition comprenant un mélange de pigment minéral et d'une fritte silicatée compatible avec la matière silicatée de l'objet, exempte de particules conductrices de l'électricité, de la couleur désirée, et en ce que l'étape (d) de fixation des compositions pigmentées déposées consiste en une cuisson à une température comprise entre 500 et 1300°C.

2. Procédé selon la revendication 1, caractérisé en ce que le motif polychrome est un motif décoratif.

3. Procédé selon la revendication 1 ou 2, caractérisé en ce qu'on effectue ladite projection de gouttelettes de colle par déplacement relatif dudit objet (1) et de ladite tête d'impression (2) pourvue de buses (3) de projection desdites gouttelettes.

4. Procédé selon l'une quelconque des revendications 1 à 3, caractérisé en ce que ledit traitement comprend une opération d'aspiration.

5. Procédé selon l'une quelconque des revendications 1 à 4, caractérisé en ce que ledit traitement comprend une opération de brossage.

6. Procédé selon l'une quelconque des revendications 1 à 4, caractérisé en ce que, après l'étape de projection des gouttelettes et avant l'étape de pulvérisation ou saupoudrage ou bien après l'étape de pulvérisation et avant l'élimination de la composition pigmentée excédentaire, on soumet la colle à une étape de traitement intermédiaire.

7. Procédé selon l'une quelconque des revendications 1 à 6, caractérisé en ce que, après ladite étape de pulvérisation ou saupoudrage, on soumet ledit objet à une étape d'uniformisation par roulage de ladite composition pigmentée collée.

8. Procédé selon l'une quelconque des revendications 1 à 7, caractérisé en ce que, préalablement à ladite étape de projection de colle, on revêt au moins ladite partie dudit objet d'une pellicule de matière plastique.

9. Procédé selon la revendication 1 pour la réalisation d'un motif sur un objet poreux, caractérisé en ce que, préalablement à l'étape (a), on procède à l'application d'une couche primaire de colle ou autre enduit visant à fermer la porosité de l'objet au moins sur la partie de ce dernier destinée à recevoir le motif.

10. Procédé selon l'une quelconque des revendications 1 à 10, caractérisé en ce que ledit objet est un article en céramique.

## Claims

1. Method of making patterns at a high resolution onto an object which comprises the following steps :
a) Printing onto an object (1) with a printing head (2) of ink jet type, droplets of glue forming the pattern (4),
b) dry spraying or sprinkling of a powder composition(6) at least on one part of the object corresponding to the pattern,
c) surface treatment of the said object to eliminate excess of the powder composition where there is no glue, and
d) definitive fixing onto the object of the powder composition according to the said pattern , characterised in that the said object is a ceramic or glass silicate compounds, that the pattern is polychrome for decoration purpose , or for marking or identification repeating steps a),b) and c), for each colour of the pattern until the polychrome pattern is obtained, using each time as powder composition (6) , a composition comprising a colour mineral pigment and a flux compatible with the ceramic or glass or silicate compounds, without conductive particles, of the required colour, and that the step (d) of fixing of the colour ceramic pigment and flux compositions is fired at a temperature comprised between 500 and 1300°C.

2. Method according to claim 1, characterised in that the polychrome pattern is for decoration purpose

3. Method according to claim 1 or 2, characterised in that printing of the glue droplets is done by moving either the said object (1) and the printing head (2) having nozzles (3) printing the said droplets.

4. Method according to any one of claims 1 to 3, characterised in that the said treatment comprises a drawing up operation .

5. Method according to any one of claims 1 to 4, characterised in that the surface treatment comprises a brushing operation.

6. Method according to any one of claims 1 to 4, characterised in that after the step of printing the droplets and before the step of dry spraying or sprinkling or after the step of dry spraying and before the step of elimination of excess colour ceramic pigment and flux powder composition, we submit the glue to an intermediate treatment step.

7. Method according to any one of claims 1 to 6, characterised in that after the said dry spaying or sprinkling step, we submit the said object to a step of rolling operation to make the surface of the said colour ceramic pigment and flux composition glued more even.

8. Method according to any one of claims 1 to 7, characterised in that before the said step of printing glue, we cover at least the said part of the said object with a layer of plastic material.

9. Method according to claim 1 for making a pattern onto porous objects, characterised in that, before step (a), we proceed to apply a layer of primary glue or other varnish to seal the porosity of the object at least on the part where the pattern is to be done.

10. Method according to any of the claims 1 to 10, characterised in that the said object is in ceramic.

## Patentansprüche

1. Realisierungsvorgang eines Motivs, mit hoher Auflösung, auf einen Gegenstand, der folgende Abschnitte umfasst :
a) Projektion auf einen Gegenstand (1) mit Hilfe eines Druckerkopfes (2), Typus Tintenstrahl, werden Leimtröpfchen nach festgelegtem Motiv (4) verteilt,
b) Zerstäubung oder Bestreuung, einer pulverförmigen Mischung (6), auf mindestens einen Teil des besagten Gegenstandes, der das genannte Motiv darstellt,
c) Behandlung der Oberfläche des besagten Gegenstandes, um die abgesetzte Mischung, auf den leimlosen Zonen zu entfernen, und
d) entgültige Fixierung der anhaftenden Mischung auf dem besagten Gegenstand, gemäss des genannten Motivs, charakterisiert dadurch, dass der besagte Gegenstand aus einem Silikatmaterial besteht. Man realisiert ein mehrfarbiges Motiv, zum Zweck der Dekoration, zur Markierung oder zur Identifizierung und wiederholt die Abschnitte a), b) und c) für jede Farbe des Motivs, bis zur Erlangung des mehrfarbigen Motivs. Verwendet wird jedes Mal als pulverförmige Mischung (6), eine Zusammensetzung, die eine Mischung aus Mineralpigmenten und einer Silikatglasmasse enthält, die mit dem Silikatmaterial des Gegenstandes vereinbar ist, ausgenommen sind stromleitenden Partikeln der erwünschten Farbe, und aus dem des Abschnittes (d) der Fixierung der niedergeschlagenen Farbstoffmasse, beruhend in der Brennung bei einer Temperatur die zwischen 500 und
1300°C liegt.

2. Verfahren gemäss der Bedingungen 1, charakterisiert dadurch, dass das mehrfarbige Motiv ein Dekorationsmotiv ist.

3. Verfahren gemäss irgend einer der Bedingungen 1 oder 2, charakterisiert dadurch, dass man die besagte Projektion der Leimtröpfchen durch Verschiebung des betroffenen Gegenstandes ausführt (1) sowie des besagten Druckerkopfes (2) versehen mit Projektionsdüsen (3) für die genannten Tröpfchen.

4. Verfahren gemäss irgend einer der Bedingungen 1 bis 3, charakterisiert dadurch, dass die besagte Behandlung ein Absaugungsverfahren enthält.

5. Verfahren gemäss irgend einer der Bedingungen 1 bis 4, charakterisiert dadurch, dass die besagte Behandlung, ein Bürstenverfahren enthält.

6. Verfahren gemäss irgend einer der Bedingungen 1 bis 4, charakterisiert dadurch, dass man den Klebstoff in einem Abschnitt einer Zwischenbehandlung unterzieht und dies nach dem Abschnitt der Tröpfchenprojektion und vor dem Abschnitt der Zerstäubung oder Bestreuung oder auch nach dem Abschnitt der Zerstäubung und vor der Entfernung der überschüssigen Farbstoffmischung.

7. Verfahren gemäss irgend einer der Bedingungen 1 bis 6, charakterisiert dadurch, dass man nach dem besagten Abschnitt der Zerstäubung oder Bestreuung, den besagten Gegenstand, einem Abschnitt der Uniformierung durch Walzen der besagten, geklebten Farbstoffmischung, unterwirft.

8. Verfahren gemäss irgend einer der Bedingungen 1 bis 7, charakterisiert dadurch, dass vor dem genannten Abschnitt der Leimprojektion, man mindestens den genannten Teil des besagten Gegenstandes mit einer Kunststoffschicht bezieht.

9. Verfahren gemäss der Bedingung 1 für die Realisierung eines Motivs auf einem porösen Gegenstand, charakterisiert dadurch, dass man vor dem Abschnitt (a), das Auftragen einer primären Leimschicht durchführt oder eines anderen Überzugs, der die Porosität des Gegenstandes zu schliessen erstrebend, und dies mindestens auf dem Teil des Gegenstandes, der dazu bestimmt ist, das Motiv aufzunehmen.

10. Verfahren gemäss irgend einer der Bedingungen 1 bis 10, charakterisiert dadurch, dass der besagten Gegenstand ein Artikel aus Keramik ist.
